# EUROPÄISCHE PATENTSCHRIFT

(11) **EP 3 631 975 B1**
(45) Veröffentlichungstag und Bekanntmachung des Hinweises auf die Patenterteilung: **06.10.2021**
(21) Anmeldenummer: 18729337.8
(22) Anmeldetag: 16.05.2018
(51) Int. Cl.: H02S 40/38, H01M 10/46, H01L 31/053

(54) **ELEKTRISCHE SCHALTUNG UND VERWENDUNG DER ELEKTRISCHEN SCHALTUNG**
ELECTRIC CIRCUIT AND USE OF THE ELECTRIC CIRCUIT
CIRCUIT ÉLECTRIQUE ET UTILISATION DU CIRCUIT ÉLECTRIQUE

(30) Priorität: 31.05.2017 DE 102017111946
(43) Veröffentlichungstag der Anmeldung: 08.04.2020
(73) Patentinhaber: TDK Electronics AG, 81671 München (DE)
(72) Erfinder: RINNER, Franz, 8523 Frauental an der Laßnitz (AT); MELISCHNIG, Alexander, 8010 Graz (AT); PICHLER, Johann, 8614 Breitenau am Hochlantsch (AT); OISHI, Masahiro, 8530 Deutschlandsberg (AT)
(74) Vertreter: Epping - Hermann - Fischer
(86) Internationale Anmeldenummer: PCT/EP2018/062773
(87) Internationale Veröffentlichungsnummer: WO 2018/219653

(56) Entgegenhaltungen:
- CN-A- 101 261 047
- CN-A- 105 553 417
- US-A- 5 631 535
- US-A1- 2008 001 577

## Beschreibung

Die Erfindung betrifft elektrische Schaltungen, z. B. für elektrische Systeme, die eine autarke Energieversorgung benötigen, und die Verwendung einer solchen Schaltung.

Es gibt Situationen, in denen an bestimmten Positionen eine elektrische Schaltung mit elektrischer Energie versorgt werden muss, ohne dass an dieser Stelle ein Stromanschluss vorhanden ist. Werden beispielsweise Veränderungen nachträglich an Gebäuden vorgenommen, so können Stromkabel verlegt werden. Das Verlegen von Stromkabeln ist im Allgemeinen dabei kostenund arbeitsintensiv und kann das ästhetische Empfinden stören.

Um beispielsweise einen Lichtschalter an einer Stelle ohne Stromversorgung anzuordnen und dort zu betreiben, kann ein Lichtschalter mit einem Funkmodul verwendet werden, wobei das Funkmodul durch eine übliche Batterie mit elektrischer Energie versorgt wird.

Eine andere Möglichkeit besteht z. B. darin, einen Schalter mit einem magnetischen oder piezoelektrischen Energiekonverter zu verwenden, der Bewegungsenergie, z. B. Energie der Bewegung einer Betätigung des Schalters, in elektrische Energie wandelt (ein so genannter Harvester). Solche Harvester sind allerdings teuer in der Anschaffung und üblicherweise auch schwergängiger.

Aus der US 2008/001577 A1 sind elektrische Bauelemente mit Solarzelle zum Wiederaufladen eines Energiespeichers bekannt.

Aus den Dokumenten CN 105553417 und CN101261047 sind ebenfalls elektrische Bauelemente mit Solarzelle und Energiespeicher bekannt. Aus der US 5,631,535 A sind Steuerschaltungen zum Aufladen eines Energiespeichers, z. B. mittels Strom aus einer Solarzelle, bekannt.

Es besteht deshalb der Wunsch nach elektrischen Schaltungen, die sich in der Bedienung von konventionellen Schaltungen, z. B. Schaltern, nicht unterscheiden und bei denen nicht regelmäßig Batterien ersetzt werden müssen.

Dazu gibt der unabhängige Anspruch eine entsprechende elektrische Schaltung an. Abhängige Ansprüche geben vorteilhafte Ausgestaltungen an.

Die elektrische Schaltung hat einen Energiewandler, einen Energiespeicher, einen ersten Anschluss und einen zweiten Anschluss. Der Energiewandler ist mit dem ersten und mit dem zweiten Anschluss elektrisch gekoppelt. Der Energiespeicher ist ebenfalls mit dem ersten und zweiten Anschluss elektrisch gekoppelt. Der Energiewandler ist dazu geeignet und dazu bestimmt, den Energiespeicher in diskreten Zeitabschnitten aufzuladen. Der Energiespeicher ist dazu geeignet und bestimmt, kontinuierlich Energie bereitzustellen. Der Energiewandler umfasst zumindest eine Solarzelle. Der Energiespeicher umfasst zumindest einen Festkörperakkumulator.

Der erste und der zweite Anschluss sind dabei im Wesentlichen die zwei Anschlüsse, über die die elektrische Schaltung elektrische Energie an weitere Schaltungskomponenten oder an eine externe Schaltungsumgebung abgeben kann. Der Energiewandler mit der Solarzelle ist dazu vorgesehen, elektromagnetische Energie, vorzugsweise im sichtbaren Spektrum, in elektrische Energie umzuwandeln. Der Energiespeicher mit seinem Festkörperakkumulator ist dazu vorgesehen, die vom Energiewandler zu bestimmten Zeitabschnitten, z. B. wenn Licht auf die Solarzelle fällt, entgegenzunehmen und zwischen zuspeichern. Das heißt, dass auch dann elektrische Energie an den beiden Anschlüssen (kontinuierlich) zur Verfügung gestellt wird, wenn kein Licht auf die Solarzelle fällt. Die elektrische Schaltung hat eine Energiequelle, die auch bei Dunkelheit Energie zur Verfügung stellt.

Der Festkörperakkumulator des Energiespeichers ist eine Bauform von Akkumulatoren, bei der seine Elektroden und der Elektrolyt zwischen den Elektroden aus einem nicht flüssigen Material bestehen.

Ein solcher Festkörperakkumulator kann mit kleinen Abmessungen und in einer Vielzahl unterschiedlicher physischer Formen hergestellt werden.

Für den Anwender ergibt sich der Vorteil, dass nicht regelmäßig Batterien ersetzt werden müssen. Gleichzeitig entsteht kein zusätzlicher Platzbedarf und die Kosten sind im Vergleich zu Lösungen mit magnetischen oder piezoelektrischen Harvestern nicht erhöht bzw. sogar verringert.

Ein gewohntes Schaltgefühl beim Betätigen eines Schalters, z. B. eines Lichtschalters, kann beibehalten werden.

Durch die Verwendung eines Festkörperakkumulators entfällt die Gefahr eines auslaufenden Elektrolyten, der in konventionellen Akkumulatoren oft korrosive Eigenschaften hat. Im Übrigen ist die Gefahr von Selbstentzündungen des Festkörperackumulators verringert. Der Akkumulator kann in praktisch jeder beliebigen Form realisiert werden. Die mechanische Beständigkeit ist besser als bei konventionellen klassischen Batterien oder Akkumulatoren, zumindest wenn der Akkumulator besonders kleine Abmessungen haben soll und dazu ohne eine stabilisierende Außenhülle ausgestaltet ist.

Als Materialien für die Elektroden oder für den Elektrolyten kommen die üblichen Materialien, die in Festkörperakkumulatoren Verwendung finden, in Frage.

Es ist möglich, dass der Energiewandler und der Energiespeicher parallel verschaltet sind.

In einer parallelen Verschaltung kann der Energiewandler, z. B. bei Lichteinfall, den Energiespeicher laden. Ferner können sowohl der Energiewandler als auch der Energiespeicher zusammen Energie an übrige Schaltungskomponenten abgeben, falls Energie beansprucht wird und gleichzeitig Licht auf die Solarzelle des Energiewandlers fällt.

Es ist möglich, dass die elektrische Schaltung zusätzlich eine Diode umfasst. Die Diode kann zwischen dem Energiespeicher und dem Energiewandler verschaltet sein. Es ist möglich, dass die Diode in Serie zwischen einer Elektrode des Energiespeichers und einer Elektrode des Energiewandlers verschaltet ist.

Die Diode dient dazu, den Energiespeicher vor einer Selbstentladung über den Energiewandler, z. B. bei Dunkelheit und einer endlichen Leitfähigkeit des Energiewandlers bei Dunkelheit, zu schützen.

Die Diode ist dabei vorzugsweise so verschaltet, dass ihr eigener Widerstand möglichst gering ist, während der Energiewandler den Energiespeicher auflädt. Für die entgegengesetzte Stromrichtung ist die Diode dann in Sperrrichtung geschaltet.

Die elektrische Schaltung weist ferner einen Varistor auf. Der Varistor ist parallel zum Energiespeicher und parallel zum Energiewandler verschaltet. Der Varistor ist ein Bauelement mit einem spannungsabhängigen Widerstand. Der elektrische Widerstand des Varistors nimmt dabei mit zunehmender angelegter Spannung ab.

Bei einer niedrigen angelegten Spannung hat der Varistor vorzugsweise einen sehr hohen elektrischen Widerstand. Bei höheren Spannungen hat der Varistor vorzugsweise einen sehr niedrigen elektrischen Widerstand.

Durch die Verwendung eines Varistors kann der Energiespeicher vor Überlastung geschützt werden, wenn beispielsweise der Energiewandler, z. B. bei starkem Lichteinfall und gefülltem Energiespeicher, oder übrige Schaltungskomponenten ein Übermaß an Energie bereitstellen.

Der Varistor dient somit als Überspannungsschutz, insbesondere für die Solarzellen.

Es ist möglich, dass die elektrische Schaltung zusätzlich ein resistives Element umfasst. Das resistive Element kann im Energiespeicher in Serie zum Festkörperakkumulator verschaltet sein.

Das resistive Element, z. B. ein ohmscher Widerstand, kann somit einen Vorwiderstand darstellen, der einen zu hohen Ladestrom verhindert.

Es ist möglich, dass die elektrische Schaltung zusätzlich ein kapazitives Element im Energiespeicher umfasst. Das kapazitive Element kann parallel zum Festkörperakkumulator verschaltet sein.

Das kapazitive Element, z. B. ein Kondensator, kann einen Stützkondensator darstellen, der den Festkörperakkumulator beim Bereitstellen elektrischer Energie einer relativ hohen elektrischen Leistung, z. B. für einen einzelnen Schaltvorgang, zur Verfügung stellt.

Festkörperakkumulatoren haben einen vergleichsweise hohen Innenwiderstand, der mit dem Kondensator kompensiert wird.

Es ist möglich, dass der Energiewandler drei oder sechs Solarzellen umfasst. Die Solarzellen können dabei in Serie verschaltet sein. Zusätzlich kann der Energiespeicher einen oder zwei Festkörperakkumulatoren umfassen, die in Serie verschaltet sind.

Eine einzelne Solarzelle kann eine Spannung von etwa 0,5 V zur Verfügung stellen, wenn sie entsprechend viel Licht empfängt.

Ein Festkörperakkumulator kann eine übliche Versorgungsspannung in Höhe von etwa 1,5 V bereitstellen, wenn er geladen ist.

Ein Festkörperakkumulator mit der Versorgungsspannung von etwa 1,5 V kann dabei übliche Batterien mit einer Versorgungsspannung von 1,5 V ersetzen.

Drei Solarzellen, die in Serie verschaltet sind und jeweils eine einzelne Versorgungsspannung von 0,5 V bereitstellen können, können zusammen eine Versorgungsspannung von etwa 1,5 V bereitstellen und sind damit gut geeignet, den Festkörperakkumulator mit einer Versorgungsspannung von 1,5 V aufzuladen.

Entsprechendes gilt für die zugehörigen Mehrfachen der Versorgungsspannungen. So können sechs in Serie verschaltete Solarzellen eine Serienverschaltung von zwei Akkumulatoren aufladen. Zwei in Serie verschaltete Akkumulatoren können dabei eine Versorgungsspannung von 3 V bereitstellen. Eine derartige elektrische Verschaltung kann einen Ersatz für eine Spannungsversorgung mit zwei in Serie geschalteten üblichen Batterien darstellen.

Entsprechend kann die elektrische Schaltung auch drei, vier, fünf, sechs, sieben, acht, neun oder zehn Festkörperakkumulatoren und entsprechend neun, zwölf, fünfzehn, achtzehn, 21, 24, 27 oder dreißig Solarzellen in Energiespeicher umfassen.

Es ist möglich, dass der Festkörperakkumulator als reflowlötbares SMD-Bauelement realisiert ist. Dies kann bei konventionellen Batterien oder Akkumulatoren sonst nicht oder nur mit einem unverhältnismäßig hohen technischen Aufwand und entsprechenden Kosten realisiert werden.

Reflow-Löten (Wiederaufschmelzlöten) ist dabei ein Weichlötverfahren zum Löten von SMD-Bauelementen. Festkörperakkumulatoren eignen sich gut zum Reflow-Löten, da ihre Bestandteile die beim Reflow-Löten auftretenden Temperaturen zumindest für die relativ kurze Zeit des Lötens gut aushalten, ohne dass der Festkörperakkumulator beschädigt wird. Das Gleiche gilt auch für die übrigen Schaltungskomponenten der elektrischen Schaltung.

Die Verwendung eines Festkörperakkumulators als SMD-Bauelement (SMD = Surface-Mounted Device (oberflächenmontiertes Bauelement)) hat den Vorteil, dass der Akkumulator leicht mit gängigen Verschaltungs- und Verbindungstechnologien zu seinen übrigen Schaltungskomponenten hinzugefügt werden kann und die elektrische Schaltung entsprechend relativ kostengünstig und mit einer geringen Ausschussquote hergestellt werden kann.

Es ist möglich, dass zumindest eine Schaltungskomponente in einem keramischen Mehrlagensubstrat eingebettet ist.

Ein keramisches Mehrlagensubstrat hat dabei zum eine keramische Lage und eine Metallisierungslage. In einer oder mehreren übereinander angeordneten Metallisierungslagen können passive Schaltungselemente, z. B. resistive Elemente, kapazitive Elemente und/oder induktive Elemente als metallisierte Strukturen gebildet sein. Das dielektrische Material der keramischen Lagen zwischen den Metallisierungslagen dient als elektrischer Isolator zwischen den Metallisierungslagen und als mechanischer Träger, der das Substrat stabilisiert. Unterschiedliche Schaltungselemente in unterschiedlichen Metallisierungslagen können durch so genannte Vias miteinander verbunden und verschaltet sein. Ein solches keramisches Mehrlagenträgersubstrat kann an seiner Oberseite oder an seiner Unterseite weitere Schaltungskomponenten, z. B. SMD-Bauelemente, aufweisen.

Das keramische Mehrlagensubstrat kann z. B. ein LTCC-Substrat (LTCC = Low-Temperature Co-fired Ceramics) oder ein HTCC-Trägersubstrat (HTTC = High-Temperature Co-fired Ceramics) sein.

Im keramischen Trägersubstrat können Ausnehmungen vorgesehen sein, in der zumindest eine oder mehrere Schaltungskomponenten, z. B. eine Solarzelle oder ein Festkörperakkumulator, eingebettet ist.

Durch das Einbetten von Schaltungskomponenten, z. B. ein monolithisches Einbetten von Schaltungskomponenten im Substrat wird die Bauhöhe des entsprechenden Bauelements, in dem die elektrische Schaltung realisiert ist, verringert.

Es ist möglich, dass zumindest zwei unterschiedliche Schaltungskomponenten in einem Modul baulich zusammengefasst sind.

Auch mehr als zwei Schaltungskomponenten können in einem einzigen Modul zusammengefasst sein. Die Schaltungskomponenten können monolithisch im Modul integriert sein. Das Modul kann SMD-montierbar ausgestaltet sein. So können z. B. der Festkörperakkumulator, die Solarzellen und weitere passive Schaltungskomponenten in einem einzigen SMD-montierbaren Modul zusammengefasst sein.

Es ist möglich, dass zumindest ein Schaltungselement in einem Gehäuse angeordnet ist, dessen Form und Größe der Form und Größe einer handelsüblichen Batterie nachempfunden ist, sodass das Gehäuse in eine Fassung für eine solche Batterie einlegbar ist.

So ist es möglich, dass ein Modul, in dem zwei oder mehrere Schaltungskomponenten zusammengefasst sind, in der Außengeometrie einer Batterie, z. B. einer Knopfzelle, ausgestaltet ist. Ein solches Modul kann eine übliche Batterie, z. B. eine übliche Knopfzelle, ersetzen oder zumindest deren Aufnahme verwenden. In bestehenden Schaltungen ist damit kein Umdesign notwendig.

Die Dimensionierung der Kapazität des Energiespeichers und der Leistung der Solarzelle können so gewählt sein, dass übliche Anforderungen erfüllt sind und dennoch geringe Herstellungskosten und geringe Abmessungen eingehalten werden können.

Wird beispielsweise ein Raum mit einer LED-Lampe in drei Meter Entfernung beleuchtet und hat die LED-Lampe eine Leistung von 10 W und hat die Solarzelle eine Fläche von etwa 4 cm² und einen Wirkungsgrad von 10 %, beträgt die Ausgangsleistung der Solarzelle etwa 0,7 µW. Ist die elektrische Schaltung ein Funk-Lichtschalter und benötigt ein einzelner Schaltvorgang etwa 100 µJ, beträgt die Ladezeit für einen einzelnen Schaltvorgang weniger als drei Minuten. Die Speicherkapazität des Festkörperakkumulators kann ca. 500 mJ betragen. Damit hat ein aufgeladener Festkörperakkumulator Energie für weit über tausend Schaltvorgänge.

Eine oben beschriebene elektrische Schaltung kann entsprechend als Energieversorgung in einer autarken Schaltung Verwendung finden.

Es ist möglich, dass die autarke Schaltung ausgewählt ist aus einer Funkschaltung, einem Lichtschalter, einer Alarmanlage, einem Brandmelder, einer Uhr, z. B. einer Wanduhr oder einer Standuhr, einer Fernbedienung, einer Wetterstation und eines Bewegungsmelders.

Es ist möglich, dass die autarke Schaltung ein Sensor, z. B. ein Funksensor, ist.

Es ist dann möglich, dass der Sensor dazu ausgestaltet ist, eine Strahlung, einen Druck, eine Temperatur, eine Feuchtigkeit, die Anwesenheit einer chemischen Substanz, ein Gas oder eine Beschleunigung zu detektieren. Es ist auch möglich, dass der Sensor dazu ausgestaltet ist, eine beliebige Kombination der diesen Paramtern zugehörigen Messgrößen zu bestimmen.

Ein Modul, in dem die Schaltung realisiert ist, kann Abmessungen (Länge x Breite) von etwa 0,305 cm x 0,254 cm aufweisen. Ein solches Modul kann also sehr kompakt gebaut werden.

Der vorliegenden elektrischen Schaltung zugrundeliegende Funktionsprinzipien und Wirkungsweisen und Details bevorzugter Ausführungsformen sind in den schematischen Figuren näher erläutert.

Es zeigen:
- Figur 1:: ein Ersatzschaltbild einer solarbetriebenen elektrischen Schaltung.
- Figur 2:: eine elektrische Schaltung mit drei in Serie verschalteten Solarzellen.
- Figur 3:: ein Ersatzschaltbild mit einer Diode.
- Figur 4:: ein Ersatzschaltbild mit einem Varistor.
- Figur 5:: ein Ersatzschaltbild mit einem resistiven Element.
- Figur 6:: ein Ersatzschaltbild mit einem kapazitiven Element.
- Figur 7:: ein Ersatzschaltbild mit zwei in Serie verschalteten Festkörperakkumulatoren.
- Figur 8:: ein Ersatzschaltbild mit mehreren bevorzugten zusätzlichen Schaltungselementen.
- Figur 9:: ein Ersatzschaltbild einer möglichen Ausgestaltung der solarbetriebenen elektrischen Schaltung.

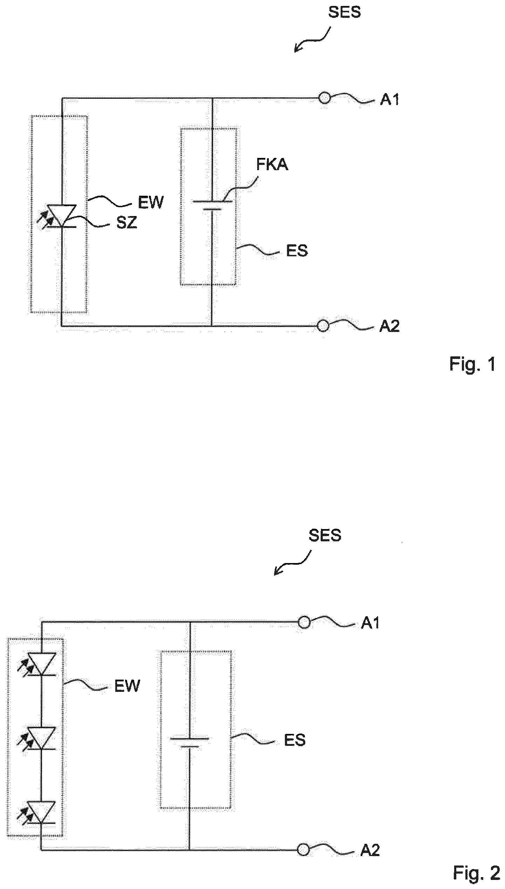

Figur 1 zeigt ein Ersatzschaltbild einer elektrischen Schaltung mit einer Solarzelle, also einer solarbetriebenen elektrischen Schaltung SES. Die Schaltung hat einen ersten Anschluss A1 und einen zweiten Anschluss A2. Zwischen dem ersten Anschluss A1 und dem zweiten Anschluss A2 ist ein Energiewandler EW elektrisch gekoppelt. Der Energiewandler EW hat zumindest eine Solarzelle SZ. Ebenfalls zwischen dem ersten Anschluss A1 und dem zweiten Anschluss A2 ist ein Energiespeicher ES elektrisch gekoppelt. Der Energiespeicher ES hat einen Festkörperakkumulator FKA. Der Energiespeicher EW und der Festkörperakkumulator FKA sind parallel zueinander zwischen den Anschlüssen A1, A2 verschaltet.

Der Energiespeicher ES und der Energiewandler EW können direkt mit den beiden Anschlüssen A1 und A2 verschaltet sein. Es ist allerdings auch möglich, dass zumindest ein Schaltungselement, z. B. der Energiewandler, über ein weiteres, optionales Schaltungselement mit einem der Anschlüsse lediglich elektrisch gekoppelt ist.

Die beiden Anschlüsse A1, A2 stellen einen Port dar, über den der Energiewandler EW und/oder der Energiespeicher ES mit weiteren Schaltungskomponenten der solarbetriebenen elektrischen Schaltung SES verschaltet sein können. Insbesondere der Energiespeicher ES stellt dabei eine Energiequelle dar, sodass die in Figur 1 gezeigten Schaltungskomponenten als Energiequelle für die in Figur 1 nicht gezeigten Schaltungselemente der solarbetriebenen elektrischen Schaltung dienen können.

Der Energiewandler EW ist dazu vorgesehen, den Energiespeicher ES dann aufzuladen, wenn der Energiespeicher ES nicht vollständig geladen ist und der Energiewandler elektromagnetische Energie in Form von Licht über seine Solarzelle empfangen kann. Bei diskreten Zeitabschnitten, während der die elektrische Schaltung SES mit Energie einer externen Umgebung versorgt wird, ist es dennoch möglich, kontinuierlich an den Anschlüssen A1, A2 eine Versorgungsspannung und elektrische Energie bereitzustellen.

Figur 2 zeigt die Möglichkeit, drei Solarzellen in Serie im Energiewandler EW zu verschalten. Der Festkörperakkumulator FKA kann dabei eine Arbeitsspannung haben, die der dreifachen Arbeitsspannung einer Solarzelle entspricht. Entsprechend gleicht eine dreifache Serienverschaltung von Solarzellen die kompatiblen Spannungen von Energiewandler EW und Energiespeicher ES aneinander an.

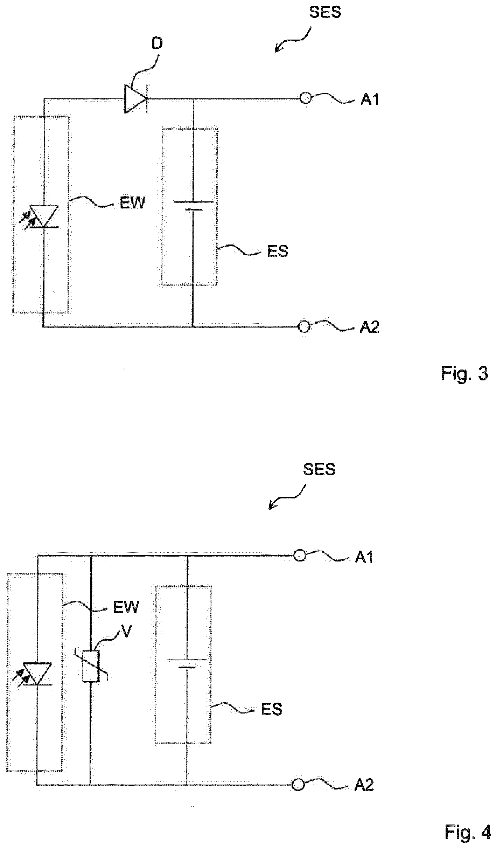

Figur 3 zeigt die Verwendung einer Diode D, die zwischen dem Energiewandler EW und dem Energiespeicher ES verschaltet ist. Die Diode D dient im Wesentlichen dazu, eine Entladung des Festkörperakkumulators bei Dunkelheit über die Solarzellen zu verhindern. Dazu ist die Diode D so geschaltet, dass sie einen geringen Eigenwiderstand beim Aufladen des Energiespeichers und einen hohen elektrischen Widerstand in der umgekehrten Stromrichtung hat.

Figur 4 zeigt die Möglichkeit, einen Varistor V parallel zum Energiewandler EW und parallel zum Energiespeicher ES zu verschalten. Der Varistor dient dabei im Wesentlichen als Überspannungsschutz für die Solarzellen bzw. für den Energiespeicher ES.

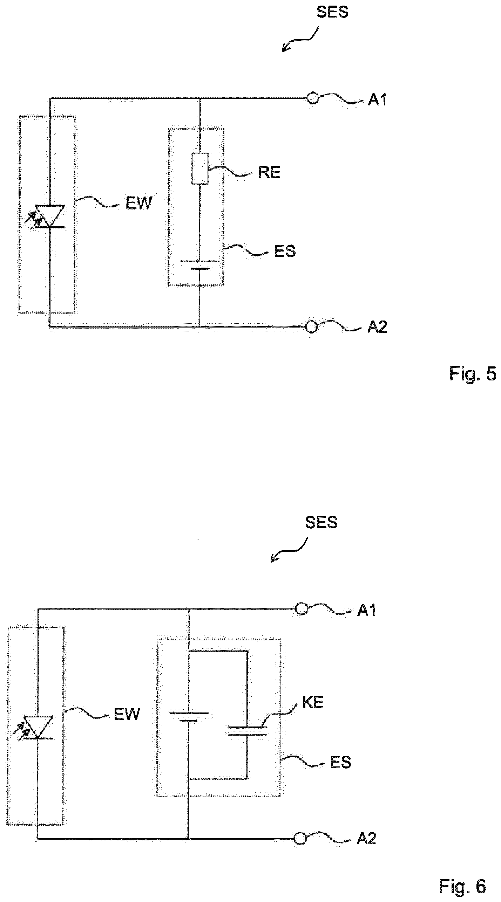

Figur 5 zeigt die Möglichkeit, ein resistives Element RE, z. B. einen ohmschen Widerstand, in Serie zum Festkörperakkumulator des Energiespeichers ES zu verschalten. Das resistive Element stellt dabei im Wesentlichen einen Vorwiderstand dar, der zu hohe Ladeströme verhindert.

Figur 6 zeigt die Möglichkeit, ein kapazitives Element KE parallel zum Festkörperakkumulator im Energiespeicher ES zu verschalten. Das kapazitive Element, z. B. ein Kondensator, stellt dabei im Wesentlich einen Stützkondensator dar, der den Festkörperakkumulator unterstützt, um Energie für ein einzelnes Ereignis zur Verfügung zu stellen. Festkörperakkumulatoren sind im Wesentlichen durch eine hohe Energiedichte, aber durch eine lediglich niedrig Leistungsdichte gekennzeichnet. Eine niedrige Leistungsdichte kann dabei durch die Verwendung des Stützkondensators kompensiert werden. Dadurch hat die elektrische Schaltung den Vorteil der hohen Energiedichte des Festkörperakkumulators, ohne direkt den Nachteil der niedrigen Leistungsdichte des Akkumulators hinnehmen zu müssen.

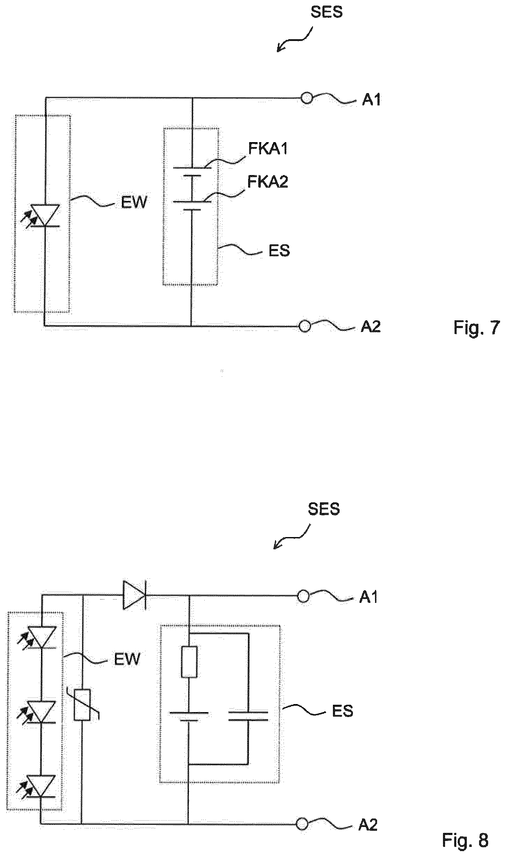

Figur 7 zeigt die Möglichkeit, zwei Festkörperakkumulatoren FKA1, FKA2 in Serie im Energiespeicher ES zu verschalten. Durch die Wahl des Grads der Kaskadierung einer entsprechenden Serien- oder Parallelverschaltung einzelner Festkörperackumulatoren im Energiespeicher ES ist es möglich, die elektrische Schaltung an eine Vielzahl unterschiedlicher Anforderungen bezüglich der Versorgungsspannung oder des Versorgungsstroms anzupassen.

Die oben gezeigten einzelnen Merkmale der Schaltungen können dabei so miteinander kombiniert werden, dass für einen konkreten Anwendungsfall geeignete Schaltungseigenschaften erhalten bleiben.

Figur 8 zeigt entsprechend eine bevorzugte Ausführungsform mit drei in Serie verschalteten Solarzellen im Energiewandler und einem resistiven und einem kapazitiven Element im Energiespeicher. Ferner hat die solarbetriebene elektrische Schaltung SES einen Varistor und eine Diode.

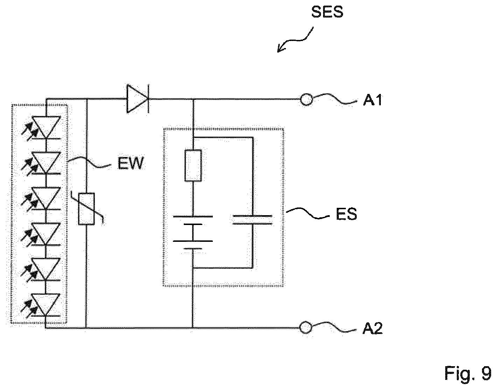

Figur 9 zeigt eine weitere Ausgestaltung, bei der zur Erhöhung der Spannung sechs Solarzellen im Energiewandler EW in Serie geschaltet sind. Im Energiespeicher ES sind zwei Akkumulatoren in Serie geschaltet.

Die elektrische Schaltung kann zusätzliche Schaltungskomponenten wie mechanische Schalter, Sensoren (z. B. für Strahlung, Druck, Temperatur, Feuchtigkeit, Chemikalien, Gase und Beschleunigung), Funkmodule zum Empfangen oder Senden elektromagnetischer Signale und weitere Energiewandler und Energiespeicher und weitere passive und aktive (z. B. integrierte elektronische Schaltungen zum Auswerten von Schaltzuständen oder von Sensormesswerten oder zum Auswerten oder Erstellen von empfangenen oder zu sendenden Funksignalen) umfassen. Weiter kann die elektrische Schaltung Schaltungskomponenten, die über die Anschlüsse A1, A2 mit elektrischer Energie versorgt werden können, umfassen.

### Bezugszeichenliste

- A1, A2:: erster, zweiter Anschluss
- D:: Diode
- ES:: Energiespeicher
- EW:: Energiewandler
- FKA:: Festkörperakkumulator
- KE:: kapazitives Element
- RE:: resistives Element
- SES:: (solarbetriebene) elektrische Schaltung
- SZ:: Solarzelle
- V:: Varistor

## Patentansprüche

1. Elektrische Schaltung (SES), umfassend
- einen Energiewandler (EW),
- einen Energiespeicher (ES),
- einen ersten Anschluss (A1) und einen zweiten Anschluss (A2)
wobei
- der Energiewandler (EW) mit dem ersten (A1) und dem zweiten (A2) Anschluss elektrisch gekoppelt ist,
- der Energiespeicher (ES) mit dem ersten (A1) und dem zweiten (A2) Anschluss elektrisch gekoppelt ist,
- der Energiewandler (EW) dazu geeignet und bestimmt ist, den Energiespeicher (ES) in diskreten Zeitabschnitten aufzuladen,
- der Energiewandler (EW) eine Solarzelle (SW) umfasst und
- der Energiespeicher (ES) einen Festkörperakkumulator (FKA) umfasst,
ferner umfassend einen Varistor (V), der parallel zum Energiespeicher (ES) und parallel zum Energiewandler (EW) verschaltet ist und **dadurch gekennzeichnet ist, dass** die elektrische Schaltung derart konfiguriert ist, eine kontinuierliche Energieabgabe an beiden Anschlüssen des Festköperakkumulators bereitzustellen.

2. Elektrische Schaltung nach dem vorherigen Anspruch, wobei der Energiewandler (EW) und der Energiespeicher (ES) parallel verschaltet sind.

3. Elektrische Schaltung nach einem der vorherigen Ansprüche, ferner umfassend eine Diode (D), die zwischen dem Energiespeicher (ES) und dem Energiewandler (EW) verschaltet ist.

4. Elektrische Schaltung nach einem der vorherigen Ansprüche, ferner umfassend ein resistives Element (RE) im Energiespeicher (ES), das in Serie zum Festkörperakkumulator (FKA) verschaltet ist.

5. Elektrische Schaltung nach einem der vorherigen Ansprüche, ferner umfassend ein kapazitives Element (KE) im Energiespeicher (ES), das parallel zum Festkörperakkumulator (FKA) verschaltet ist.

6. Elektrische Schaltung nach einem der vorherigen Ansprüche, wobei
- der Energiewandler (EW) drei oder sechs Solarzellen (SZ), die in Serie verschaltet sind, umfasst und
- der Energiespeicher (ES) einen oder zwei Festkörperakkumulatoren (FKA), die in Serie verschaltet sind, umfasst.

7. Elektrische Schaltung nach einem der vorherigen Ansprüche, wobei zumindest ein Festkörperakkumulator (FKA) als reflowlötbares SMD-Bauelement realisiert ist.

8. Elektrische Schaltung nach einem der vorherigen Ansprüche, wobei zumindest eine Schaltungskomponente in einem keramischen Mehrlagensubstrat eingebettet ist.

9. Elektrische Schaltung nach einem der vorherigen Ansprüche, wobei zumindest zwei unterschiedliche Schaltungskomponenten in einem Modul baulich zusammengefasst sind.

10. Elektrische Schaltung nach einem der vorherigen Ansprüche, wobei zumindest ein Schaltungselement in einem Gehäuse angeordnet ist, dessen Form und Größe der Form und Größe einer handelsüblichen Batterie nachempfunden ist, so dass das Gehäuse in eine Fassung für eine solche Batterie einlegbar ist.

11. Verwendung einer elektrischen Schaltung nach einem der vorherigen Ansprüche als Energieversorgung in einer autarken Schaltung.

12. Verwendung nach dem vorherigen Anspruch, wobei die autarke Schaltung ausgewählt ist aus einer Funkschaltung, einem Lichtschalter, einer Alarmanlage, einem Brandmelder, einem einer Uhr, einer Fernbedienung, einer Wetterstation und eines Bewegungsmelders.

13. Verwendung nach Anspruch 12, wobei die autarke Schaltung ausgewählt ist aus einem Sensor und einem Funksensor.

14. Verwendung nach dem vorherigen Anspruch, wobei der Sensor dazu ausgestaltet ist, eine Strahlung, einen Druck, eine Temperatur, eine Feuchtigkeit, die Anwesenheit einer chemischen Substanz, ein Gas oder eine Beschleunigung oder eine beliebige Kombination hiervon zu detektieren.

## Claims

1. Electrical circuit (SES), comprising
- an energy converter (EW),
- an energy store (ES),
- a first connection (A1) and a second connection (A2),
wherein
- the energy converter (EW) is electrically coupled to the first (A1) and the second (A2) connection,
- the energy store (ES) is electrically coupled to the first (A1) and the second (A2) connection,
- the energy converter (EW) is suitable and intended for charging the energy store (ES) at discrete time periods,
- the energy converter (EW) comprises a solar cell (SW), and
- the energy store (ES) comprises a solid-state accumulator (FKA),
further comprising a varistor (V) that is connected in parallel with the energy store (ES) and in parallel with the energy converter (EW), and **characterized in that** the electrical circuit is configured in such a way as to provide a continuous output of energy at both connections of the solid-state accumulator.

2. Electrical circuit according to the preceding claim, wherein the energy converter (EW) and the energy store (ES) are connected in parallel.

3. Electrical circuit according to either of the preceding claims, further comprising a diode (D) that is connected between the energy store (ES) and the energy converter (EW).

4. Electrical circuit according to one of the preceding claims, further comprising, in the energy store (ES), a resistive element (RE) that is connected in series with the solid-state accumulator (FKA).

5. Electrical circuit according to one of the preceding claims, further comprising, in the energy store (ES), a capacitive element (KE) that is connected in parallel with the solid-state accumulator (FKA).

6. Electrical circuit according to one of the preceding claims, wherein
- the energy converter (EW) comprises three or six solar cells (SZ) that are connected in series, and
- the energy store (ES) comprises one or two solid-state accumulators (FKA) that are connected in series.

7. Electrical circuit according to one of the preceding claims, wherein at least one solid-state accumulator (FKA) is in the form of a reflow-solderable SMD component.

8. Electrical circuit according to one of the preceding claims, wherein at least one circuit component is embedded in a ceramic multilayer substrate.

9. Electrical circuit according to one of the preceding claims, wherein at least two different circuit components are physically combined in a module.

10. Electrical circuit according to one of the preceding claims, wherein at least one circuit element is arranged in a housing, the shape and size of which are based on the shape and size of a commercially available battery so that the housing can be inserted into a holder for such a battery.

11. Use of an electrical circuit according to one of the preceding claims as an energy supply in an independent circuit.

12. Use according to the preceding claim, wherein the independent circuit is selected from a radio circuit, a light switch, an alarm system, a fire alarm, a clock, a remote control, a weather station and a motion detector.

13. Use according to Claim 12, wherein the independent circuit is selected from a sensor and a radio sensor.

14. Use according to the preceding claim, wherein the sensor is configured to detect radiation, a pressure, a temperature, a humidity, the presence of a chemical substance, a gas or an acceleration or any combination thereof.

## Revendications

1. Circuit électrique (SES), comprenant
- un convertisseur d'énergie (EW),
- un accumulateur d'énergie (ES),
- une première borne (A1) et une deuxième borne (A2)
- le convertisseur d'énergie (EW) étant couplé électriquement à la première (A1) et à la deuxième (A2) borne,
- l'accumulateur d'énergie (ES) étant couplé électriquement à la première (A1) et à la deuxième (A2) borne,
- le convertisseur d'énergie (EW) étant adapté pour, et destiné à, charger l'accumulateur d'énergie (ES) en segments temporels discrets,
- le convertisseur d'énergie (EW) comprenant une cellule solaire (SW) et
- l'accumulateur d'énergie {ES} comprend un accumulateur à l'état solide (FKA) ;
ledit circuit électrique comprenant en outre une varistance (V) qui est monté en parallèle avec l'accumulateur d'énergie (ES) et en parallèle avec le convertisseur d'énergie (EW) et étant **caractérisé en ce que** le circuit électrique est configuré pour fournir une sortie d'énergie continue aux deux bornes de l'accumulateur à l'état solide.

2. Circuit électrique selon la revendication précédente, le convertisseur d'énergie (EW) et l'accumulateur d'énergie (ES) étant montés en parallèle.

3. Circuit électrique selon l'une des revendications précédentes, comprenant en outre une diode (D) qui est montée entre l'accumulateur d'énergie (ES) et le convertisseur d'énergie (EW).

4. Circuit électrique selon l'une des revendications précédentes, comprenant en outre un élément résistif (RE) qui est situé dans l'accumulateur d'énergie (ES) et qui est monté en série avec l'accumulateur à l'état solide (FKA).

5. Circuit électrique selon l'une des revendications précédentes, comprenant en outre un élément capacitif (KE) qui est situé dans l'accumulateur d'énergie (ES) et qui est monté en parallèle avec l'accumulateur à l'état solide (FKA).

6. Circuit électrique selon l'une des revendications précédentes,
- le convertisseur d'énergie (EW) comprenant trois ou six cellules solaires (SZ) montées en série et
- l'accumulateur d'énergie (ES) comprenant un ou deux accumulateurs à l'état solide (FKA) qui sont montés en série.

7. Circuit électrique selon l'une des revendications précédentes, au moins un accumulateur à l'état solide (FKA) étant réalisé sous la forme d'un composant CMS soudable par refusion.

8. Circuit électrique selon l'une des revendications précédentes, au moins un composant de circuit étant incorporé dans un substrat céramique multicouche.

9. Circuit électrique selon l'une des revendications précédentes, au moins deux composants de circuit différents étant structurellement combinés dans un même module.

10. Circuit électrique selon l'une des revendications précédentes, au moins un élément de circuit étant disposé dans un boîtier dont la forme et la dimension sont calquées sur la forme et la dimension d'une batterie du commerce, de sorte que le boîtier puisse être inséré dans un support destiné à une telle batterie.

11. Utilisation d'un circuit électrique selon l'une des revendications précédentes comme alimentation en énergie dans un circuit autonome.

12. Utilisation selon la revendication précédente, le circuit autonome étant choisi parmi un circuit radio, un interrupteur d'éclairage, un système d'alarme, un détecteur incendie, une horloge, une télécommande, une station météo et un détecteur de mouvement.

13. Utilisation selon la revendication 12, le circuit autonome étant choisi parmi un capteur et un capteur radio.

14. Utilisation selon la revendication précédente, le capteur étant destiné à détecter un rayonnement, une pression, une température, une humidité, la présence d'une substance chimique, un gaz ou une accélération ou toute combinaison de ceux-ci.
